## Europäisches Patentamt

## European Patent Office

## Office européen des brevets

(11) Publication number: **0 067 521**
**B1**

## EUROPEAN PATENT SPECIFICATION

(45) Date of publication of patent specification: **08.07.87**

(21) Application number: **82302369.2**

(22) Date of filing: **10.05.82**

(51) Int. Cl.⁴: **H 01 S 3/16,** C 30 B 15/00,
C 30 B 29/28

(54) **Process for maximizing laser crystal efficiency by effecting single site for dopant.**

(30) Priority: **04.06.81 US 270674**

(43) Date of publication of application:
**22.12.82 Bulletin 82/51**

(45) Publication of the grant of the patent:
**08.07.87 Bulletin 87/28**

(84) Designated Contracting States:
**DE FR GB IT NL**

(56) References cited:
DE-A-1 544 331
FR-A-2 450 885

JOURNAL OF CRYSTAL GROWTH, vol. 42, no.
1, December 1977, pages 440-444, North-
Holland Publishing Co., Amsterdam, NL; D.
MATEIKA et al.: "Coupled substitution of
gallium by magnesium and zirconium in single
crystals of gadolinium gallium garnet"

JOURNAL OF THE AMERICAN CERAMIC
SOCIETY, vol. 48, no. 2, February 1965, pages
105-108, American Ceramic Society, New York,
US; L.G. VAN UITERT et al.: "Growth of large
optical-quality yttrium and rare-earth
aluminum garnets"

(73) Proprietor: **Hughes Aircraft Company**
**7200 Hughes Terrace P.O. Box 45066**
**Los Angeles California 90045-0066 (US)**

(72) Inventor: **Devor, Donald P.**
**4965 Reforma Road**
**Woodland Hills California 91364 (US)**
Inventor: **Pastor, Ricardo C.**
**2201 Manzanita Lane**
**Manhattan Beach California 90266 (US)**
Inventor: **DeShazer, Larry G.**
**30 Rollingwood Drive**
**Rolling Hills Estates California 90274 (US)**

(74) Representative: **Colgan, Stephen James et al**
**CARPMAELS & RANSFORD 43 Bloomsbury**
**Square**
**London WC1A 2RA. (GB)**

Courier Press, Leamington Spa, England.

**Description**

Background of the invention
1. Field of the invention

This invention relates generally to the field of laser materials and, more particularly, to a process for maximizing the lasing efficiency of a dopant-containing laser oxide material, such as neodymium-doped yttrium aluminum garnet.

2. Description of the prior art

A laser beam is produced by introducing light into a host material which contains an active ingredient, to raise the atoms of the active ingredient to higher energy levels. Subsequently, a number of these active atoms return to their original energy state, doing so in phase, and produce radiation of the same frequency, thus producing a laser beam. The first laser action was produced using chromium as the active ingredient in a ruby host material. Later, lasing action was produced by neodymium contained in a glass host material. One system of current importance in laser technology uses neodymium (Nd) as the active ingredient and yttrium aluminum garnet (YAG) as the host material, as discussed by A. E. Siegman in the book entitled "An Introduction to Lasers and Masers," McGraw-Hill Book Company, New York, 1971 and also in U.S. Patent No. 4,13,501. Nd:YAG lasers are particularly useful for the application of optical methods to measure distance, such as in range finders and in target designators and target illuminators.

One of the objectives of laser technology has been to increase the lasing efficiency (or fluorescence yield) of a laser so that the laser energy output can be maximized for a given input energy. Initial measurements by S. Singh, R. G. Smith and L. G. Van Uitert, in a publication entitled "Stimulated-emission cross-section and fluorescent quantum efficiency of $Nd^{3+}$ in yttrium aluminum garnet at room temperature," *Physical Review B,* Vol. 10, No. 6, 15 September 1974, pp. 2566—2572, indicated that the absolute radiative quantum efficiency of the $^4F_{3/2}$ state of $Nd^{3+}$ in YAG was 56 percent. Further work by S. Singh, W. A. Bonner, W. H. Grodkiewicz, M. Grasso, and L. G. Van Uitert, reported in a publication entitled "Nd-doped yttrium aluminum garnet with improved fluorescent lifetime of the $^4F_{3/2}$ state," *Applied Physics Letters,* Vol. 29, No. 6, 15 September 1976, pp. 343—345, was aimed at improving the fluorescent lifetime of the metastable level of the laser transition, and approached this problem by preparing a Nd-doped YAG composition in powdered form. Another approach to improving lasing efficiency was taken by J. W. Strozyk as described in a publication entitlted "Lutetium effects on the UN absorption spectra of Nd:YAG," in *IEEE Journal of Quantum Electronics* (Correspondence), Vol. QE-7, September 1971, pp. 467—469, where lutetium was intended to promote the activity of the Nd atoms and thus improve lasing efficiency. Such an addition of certain metal ions to a laser material to improve lasing properties has been known in the art. For example, chromium ions have been added to a neodymium-doped laser material so that the chromium ions can absorb energy and transfer it to the neodymium ions, thereby permitting excitation of the neodymium ions over a wider energy band, as discussed by R. C. Ohlmann and R. Mazelsky, in the publication entitled "Energy transfer from $Cr^{3+}$ to $Nd^{3+}$ in solids", in *Physics of Quantum Electronics,* San Juan, Puerto Rico, McGraw-Hill, New York, 1966, pp 322—331. In addition, it has been known that lasing efficiency can be improved by removing from the laser material metal ion impurities which quench the lasing action, as discussed by L. A. Riseberg and M. J. Weber, in "Relaxation phenomena in rare earth luminescence," in *Progress in Optics*, edited by E. Wolf, Elsevier North Ireland, New York, 1976.

Most recently it has been disclosed in U.S. Patent No. 4,315,832 (see also FR—A—2 450 885) that the lasing efficiency of a Nd:YAG laser crystal can be increased to approximately 85 percent by exposing the doped laser crystal to an atmosphere conducive to the formation of atomic oxygen to allow the atomic oxygen to react with and remove water and water-derived impurities from the laser crystal. In one preferred process embodiment of the invention set forth in U.S. Patent No. 4,315,832 (FR—A—2 450 885), the doped laser crystal is heated at 1500°C in a vapor mixture of oxygen and iodine having mole concentrations in the ratio of 10:1, to produce the required atomic oxygen to react with and remove the impurities in the laser crystal. While the above-described process provides a laser oxide material which is hightly satisfactory for many applications, the present invention provides still additional new and improved processes for increasing the lasing efficiency of laser oxide materials even further.

Summary of the invention

The purpose of the present invention as claimed is to provide new and improved processes as claimed in independent claims 1, 2, 6 and 11 for maximizing the lasing efficiency of dopant-containing laser oxide materials, and the improved lasing materials formed by such processes, and as claimed in independant claims 7 and 10.

In order to accomplish this purpose, we have discovered and developed a process in which anion stoichiometry in the crystal structure of the laser oxide material is enhanced, prior to and during formation of the dopant-containing laser oxide material, which thereby maximizes the location of the dopant ions in a single selected site of the crystal structure of the laser oxide material, with this site being substantially free of defects caused by the absence of anion stoichiometry. More particularly, in a preferred process embodiment of the present invention, a dopant-containing laser oxide material is provided in the form of a powder. The powdered material is placed in a crystal growth chamber adapted for crystal growth from a melt, and the powder is heated at a predetermined elevated temperature in a reactive atmosphere comprising atomic oxygen for a predetermined period of time to allow the reactive atmosphere to react with and remove water and water-derived impurities from the powder. Next, the powder is melted. Finally, the crystal of the dopant-containing laser oxide material is grown from the melt, under the reactive atmosphere.

By this process, the ions of the dopant in the grown crystal are located at a single selected site of the crystal structure of the laser oxide material, with this site being substantially free of crystal defects caused by anion or anion-related impurities in the crystal structure. These selectively located neodymium ions subsequently produce a preferential radiative energy transition upon energetic excitation of the laser oxide material, which maximizes the lasing efficiency of the doped laser oxide material.

Accordingly, it is a purpose of the present invention to provide new and improved processes for improving the anion stoichiometry in the crystal structure of a doped laser oxide material and thereby maximizing the lasing efficiency of this later material.

Another purpose of the present invention is to provide a new and improved process for maximizing lasing efficiency, in which dopant ions in a laser oxide host material are located in a preferential site of the crystal structure of the laser oxide material, with this site being substantially free of defects caused by the presence of anion or anion-related impurities in the crystal structure and their attendant production of anion off-stoichiometry.

Still another purpose of the present invention is to provide a process of the type described in which substantially all deflect-related dopant sites in the crystal structure of a laser oxide material are removed and consequently the preferred normal dopant sites in this crystal structure are maximized.

Yet another purpose is to provide a process of the type described in which the dopant ions located in the preferred normal dopant sites produce a preferential radiative energy transition upon energetic excitation of the laser oxide material, thereby maximizing the lasing efficiency of this laser oxide material.

A further purpose of the present invention is to provide new and improved dopant-containing laser oxide materials having maximized lasing efficiency.

Another purpose is to provide new materials of the type described in which dopant ions are located at a preferential single site of the crystal structure of the host laser oxide material, with this site being substantially free of lattice defects induced by anion or anion-related impurities and their attendant production of anion off-stoichiometry.

A particular purpose of the present invention is to provide a new material of the type described comprising a yttrium aluminum garnet host laser oxide material and neodymium dopant ions, and having maximized lasing efficiency.

The foregoing and other advantages will be apparent from the following more particular description of the preferred embodiments of the invention, as illustrated in the accompanying drawings.

Brief description of the drawings

Fig. 1 is a graphic presentation of the data measured for the quantum efficiency of a commercially available Nd:YAG crystal at various temperatures.

Fig. 2 is a graphic presentation of the effect of temperature change on the Nd-YAG fluorescence e-folding lifetime of a commercially available crystal.

Fig. 3 presents the excitation spectra generated by a commercially available Nd:YAG crystal at 6.8K using selective site spectroscopy.

Fig. 4 shows, in schematic form, an experimental test set-up suitable for generating the spectra shown in Fig. 3.

Fig. 5 presents the excitation spectrum generated at 8K from a Nd:YAG sample treated in accordance with one process embodiment of the present invention and indicating a single site for the dopant.

Fig. 6 shows, in schematic form, one apparatus suitable for generating the reactive atmosphere required in several process embodiments of the present invention.

Detailed description of the invention

The yttrium aluminum garnet ($Y_3Al_5O_{12}$) crystal has a cubic structure. In this YAG crystal, yttrium ions ($Y^{3+}$) occupy only dodecahedral sites and aluminum ions ($Al^{3+}$) occupy octahedral and tetrahedral sites. When the YAG crystal is doped with neodymium, neodymium ions ($Nd^{3+}$) are substituted for $Y^{3+}$ ions in the crystal structure. Strictly speaking, doping YAG with $Nd^{3+}$ produces a defect because the $Nd^{3+}$ ionic radius of 0.0995 nm (0.005 angstroms) is too large to substitute precisely for the $Y^{3+}$ ion having a radius of 0.0893 nm (0.893 angstroms). In the past, it had been thought that the observed strain-broadening of fluorescence linewidths of Nd:YAG and the reduced lasing efficiency were due to this misfit, as studied, for example, in the work of Strozyk previously referenced herein. However, in a different approach, as disclosed in U.S. Patent No. 4,315,832 (FR—A—2 450 885) referenced above, it was observed that the removal of water and water-derived impurities from the Nd-doped YAG crystal improved the lasing efficiency of the Nd:YAG crystal.

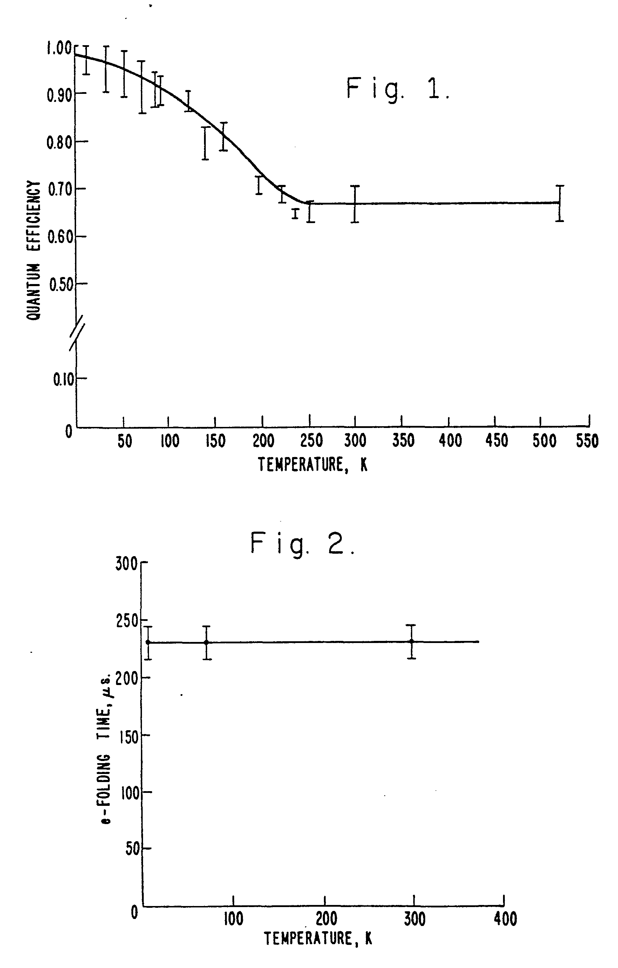

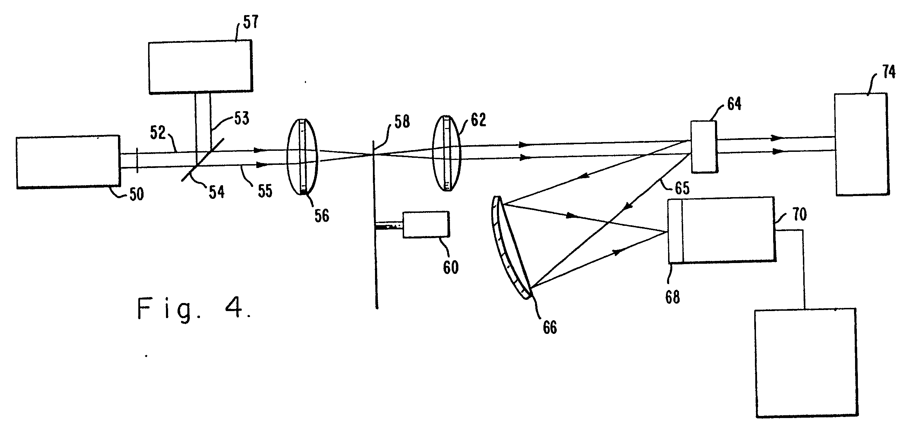

As a further development, we demonstrated that the quantum efficiency (i.e., the ratio of the photons emitted to the photons absorbed) of the Nd:YAG crystal is highly temperature dependent. Fig. 1 is a graphic presentation of the data measured for the quantum efficiency of a commercially available Nd:YAG crystal at various temperatures from approximately 7 degrees Kelvin (K) to approximately 520K (In Fig. 1, ranges of measured data are represented by vertical bars.) As can be seen in Fig. 1, at 7K, the quantum efficiency is nearly 100 percent and decreases with an increase in temperature to approximately 200K, where the quantum efficiency levels out at approximately 65 percent. The quantum efficiency was determined by detecting the fluorescence power emitted per power absorbed using a test set-up of the type described herein in relation to Fig. 4.

In order to understand this temperature dependence of the quantum efficiency of Nd:YAG crystals, we examined the fluorescence lifetime curve of the commercially available Nd:YAG crystal. We discovered that the fluorescence decay of the Nd:YAG is non-exponential, which is a departure from the exponential fluorescence decay expected from a single site doped YAG material. We then determined the e-folding lifetime, which is the time for the fluorescence intensity to drop $I_0/e$, where $I_0$ is the original fluorescence intensity and $e=2.71828$, for Nd:YAG at various temperatures. Fig. 2 is a graphic presentation of the data obtained, showing ranges of measured data as vertical bars. Fig. 2 illustrates that the e-folding time is nearly constant from approximately 7K to approximately 300K. These data were obtained by measuring fluorescence intensity versus time using a test set-up of the type described in relation to Fig. 4, with the chopper 60 being activated.

Thus, Fig. 1 shows that the quantum efficiency of Nd:YAG changes with temperature and Fig. 2 shows that the fluorescence lifetime remains constant with temperature change. However, for homogeneous or single dopant site, these two quantities are related by the equation:

$$\eta = \frac{\tau}{\tau_R} \qquad (1)$$

where

$\eta$ = quantum efficiency

$\tau$ = fluorescence lifetime

$\tau_R$ = radiative lifetime constant

Thus, in accordance with Equation (1), if the fluorescence lifetime remains constant, the quantum efficiency cannot change, which is in contradiction to our experimental results described above. We concluded that the observed effects on quantum efficiency and fluorescence lifetime discussed above were due to neodymium ions in two or more non-equivalent sites in the YAG crystal.

We then demonstrated the presence of the following two separate Nd-dopant sites in the YAG crystal: (a) the first site is the normal substitutional site, in which the $Nd^{3+}$ ion substitutes for the $Y^{3+}$ ion in the normal dodecahedral site; and (b) the second site is a defect-related dodecahedral site which is coupled to crystal defects, and in which the $Nd^{3+}$ ions are coordinated in sites where the local crystal field and consequently the electrical properties of the dopant ions are altered by the presence of anion or anion-related impurities in the YAG crystal.

The crystal lattice defects discussed above are due to an absence of anion stoichiometry, which is referred to herein as "anion off-stoichiometry," and which is caused either by the presence of impurity anions or the absence of a desired anion, either of which alters the local electric field in the crystal. These impurities are most frequently water or water-derived hydroxyl ions or hydrogen ions. This change in the local crystal field, in turn, alters the behavior of $Nd^{3+}$ ions in the environment of this crystal field and, in particular, alters the fluorescence transition frequency of the $Nd^{3+}$ ions.

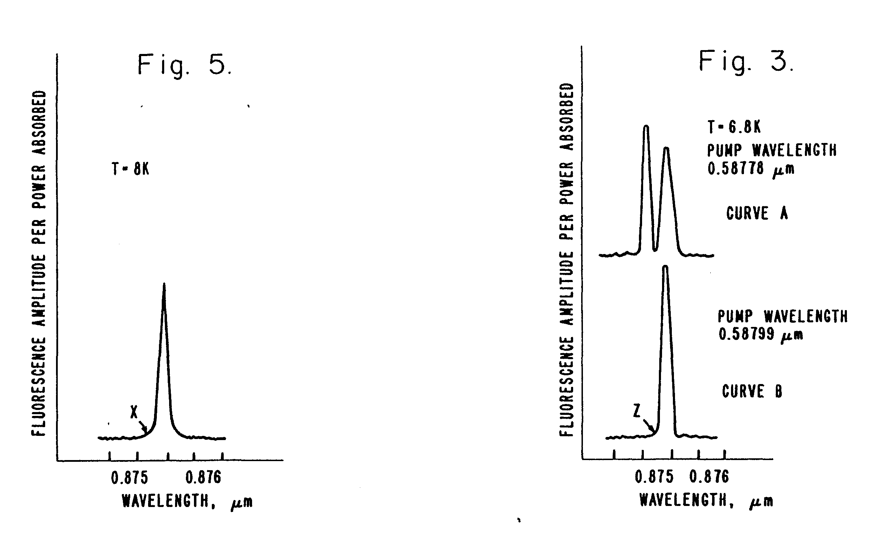

We further demonstrated that the $Nd^{3+}$ ions in these two sites in the YAG crystal produce fluorescence outputs of differing wavelengths and that the preferred fluorescence output is obtained from the $Nd^{3+}$ ion in the normal dodecahedral site of the YAG crystal as discussed below in relation to Fig. 3.

Turning now to Fig. 3, there is shown the excitation spectra for a commercially available Nd:YAG crystal, obtained at 6.8K by selective site spectroscopy using the experimental test set-up described in Fig. 4 below. A sample of a commercially available Nd:YAG crystal (for example, from Litton Airtron of Morris Plains, New Jersey) containing 1 atomic percent of neodymium dopant and having dimensions of 3 to 6 millimeters in diameter and approximately 6 millimeters in length was used. A tunable dye laser of 0.5 $centimeter^{-1}$ linewidth and output powers in the range of 0.3 to 1.0 watt was used to excite fluorescence of the crystal. First, the dye laser was tuned to the peak of a strong absorption line and the fluorescence spectrum shown as Curve B of Fig. 3 was recorded. However, the detected fluorescence showed weak sidebands, such as at point "Z" of Curve B. Subsequently, the dye laser was tuned off the peak of the absorption line, to enhance this sideband fluorescence, and the spectrum shown in Fig. 3, Curve A was obtained. As shown in Fig. 3, Curve A, an "extra" fluorescence output was obtained at approximately 0.8751 micrometers, as well as the main output at approximately 0.8754 micrometers.

We concluded that the preferential main output at 0.8754 micrometers was due to excitation of neodymium ions in the normal dodecahedral site of the YAG crystal lattice, whereas the "extra" output at 0.8751 micrometers was due to excitation of neodymium ions in the defect-related sites in the YAG crystal lattice. The unanticipated appearance of the main line in addition to the "extra" line in Curve A of Fig. 3 indicates an overlap of absorption spectra of ions in the normal and the defect-related sites, and also possible energy transfer between ions in the different sites. Furthermore, additional spectra generated in a manner similar to the spectra shown in Fig. 3 indicate that these defect sites affect the entire spectrum of the neodymium ions transitions.

We then repeated the above-described site selection spectroscopy at elevated temperatures. We further discovered that the fluorescence for the $Nd^{3+}$ ions in defect-related sites was completely quenched at temperatures above 90K. The quantum efficiency for the $Nd^{3+}$ ions in the normal site varied from nearly 100 percent at 7K to 64 percent at room temperature. This radiation quenching process was observed by recording the fluorescence per absorbed power for a crystal held at constant temperature, with temperatures in the range of 4.2K to 535K. Site selection fluorescence was used as previously described to record the 0.8754 micrometer and the 0.8751 micrometer output lines. It was determined that, when allowance was made for the thermal shift of line center wavelengths, the 0.8751 micrometer line of Fig. 3 was quenched to extinction at 80K and that the 0.8754 micrometer line began to show quenching at higher temperatures.

With our previously described observations of the defect site spectra, the change of quantum efficiency with temperature as shown in Fig. 1 can now be explained. The temperature variation of quantum efficiency is due to the transfer of energy through the crystal lattice from neodymium ions in the first or normal site at 0.8754 micrometer to neodymium ions in the second or defect-related site at 0.8751 micrometer, with this transfer being strongly temperature-dependent. The defect-related dopant site acts as an energy sink, giving up the transferred energy to the crystal lattice, which becomes heat. Thus, the neodymium ions in the normal site are robbed of the energy needed to produce an efficient fluorescence output. Ultimately, at room temperature, the quantum efficiency is regulated only by neodymium ions in the second site. However, at low temperature, such as 6.8K, this energy transfer mechanism is greatly reduced and neodymium ions in the first site are no longer controlled by neodymium ions in the second site.

Furthermore, by examining Fig. 1 which has been discussed above, it can be seen that at low temperature (e.g., 7K), the quantum efficiency of the Nd:YAG sample approaches 100 percent. However, as discussed immediately above, this effect is due to neodymium ions in the normal site, which have nearly 100 percent quantum efficiency at low temperature. Consequently, we concluded that by maximizing the location of neodymium ions in the normal dopant site of the YAG crystal and minimizing the location of neodymium ions in the less efficient and energy-robbing defect-related site, the quantum efficiency of the crystal can be significantly increased at higher temperatures (e.g., room temperature).

In accordance with the present invention, this maximized lasing efficiency is accomplished by improving anion stoichiometry in the Nd:YAG crystal as formed and thus eliminating the anion off-stoichiometry which causes the undesired defect-related sites for the $Nd^{3+}$ ions. Thus, all or most of the $Nd^{3+}$ ions are located in the normal sites, and few, if any, $Nd^{3+}$ ions are located in sites associated with anion or anion-related defects in the crystal, since the source of these defects has been removed.

In Fig. 4, there is shown, in schematic form, an experimental test set-up which was used to generate the site selection spectra shown in Fig. 3 and discussed above. A laser 50 produces an output beam 52 of a specified wavelength, which is stabilized by an internal etalon and power feedback network. Room temperature fluorescence output can be measured using argon laser excitation, while low temperature fluorescence output measurements require a dye laser tuned to a specific absorption line. The beam 52 strikes the beam splitter 54, to split the beam into the portions 53 and 55. The beam portion 53 strikes the thermopile 57 which measures the power incident on the Nd-doped YAG sample 64. The beam portion 55 passes through the focusing lens 56 whereby the beam 55 is focused to a point in the plane of blade 58 of a motor driven chopper 60, which turns the beam 55 on and off, to provide a means to measure the fluorescence rise and decay rates. Next, the focused beam passes through a collimating lens 62 and then strikes the Nd-doped YAG laser rod sample 64. Optionally, for measurements of fluorescence output at various temperatures, the laser rod sample may be contained in a heater or on a cold finger in the vacuum space of a transmission dewar (not shown). The laser beam striking the Nd:YAG sample 64 causes the sample 64 to produce fluorescent rays 65 which are collected by the spherical mirror 66, having a 0.25 meter radius. The mirror 66 reflects the fluorescent rays and images then on an interference filter 68 which passes a preselected wavelength of radiation, such as 1.06 micrometer radiation. The radiation passed by filter 68 strikes the detector 70 which may be a monochromator used to resolve the crystal fluorescence transition lines, or a power meter equipped with a suitable filter and used to measure fluorescence output power per absorbed laser excitation power and thus provide quantum efficiency data. A portion of the laser beam which strikes the Nd:YAG sample 64 is transmitted thereby and detected by the thermopile 74. The test set-up shown in Fig. 4 was used to generate the spectra shown in Fig. 3 and discussed above.

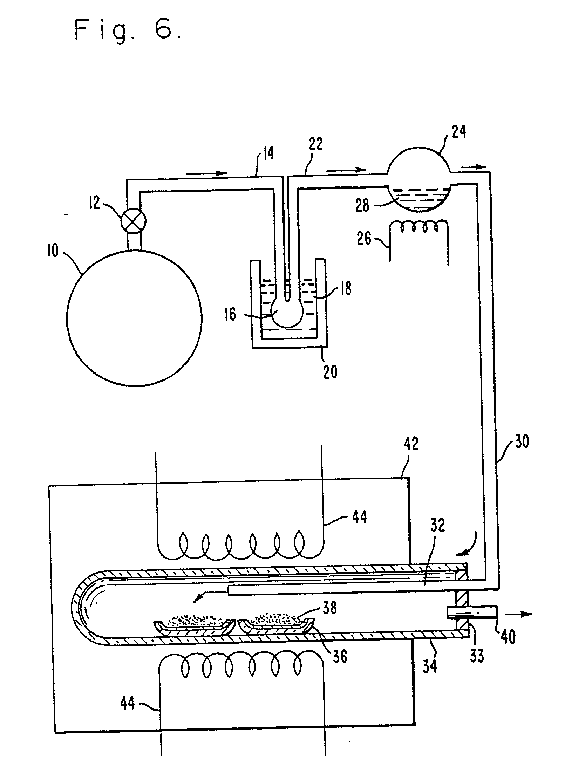

In Fig. 5 there is shown the fluorescence spectrum generated at 8K by using selective site spectroscopy for a Nd:YAG crystal containing 1 atomic percent of neodymium, which has been formed in accordance with the second process embodiment of the present invention described below with regard to Fig. 6. This process includes, among other things, reactive atmosphere processing of a commercially available Nd:YAG powder with $I_2$ and $O_2$, $CO_2$ laser melting of the treated powder, and growth of a Nd:YAG crystal from the melt under the reactive atmosphere. The spectrum shown in Fig. 5 was generated in the manner previously described in relation to Fig. 3, Curve A. The dye laser was first tuned to the peak of a strong absorption line and a fluorescence spectrum nearly identical to that shown in Fig. 5 was obtained. Then, the dye laser was tuned off the peak of the absorption line to try to enhance the sideband absorption, and the fluorescence spectrum shown in Fig. 5 was obtained. As indicated in Fig. 5 at the point designated "X", there is no sideband absorption, which indicates that the defect-related fluorescence output has been essentially removed from the Nd:YAG crystal has a single dopant site, which provides a fluorescence output at 0.8754 micrometer. Fig. 5 should be compared to Fig. 3, Curve A which indicates the fluorescence output for an untreated Nd:YAG material, in which sideband absorption due to defect-related dopant sites is present.

Thus, by practicing the process of the present invention as described herein, a neodymium-doped YAG material having maximized lasing efficiency, heretofore unobtained, is produced. This new Nd:YAG material is characterized by having neodymium ions located in a single selected site of the YAG crystal structure, which is the "normal" dodecahedral site substantially free of lattice defects induced by anion or anion-related impurities in the crystal. In particular, these lattice defects would arise from anion off-stoichiometry in the crystal. Upon subsequent energetic excitation of this Nd:YAG material, these preferentially located neodymium ions undergo a preferential radiative transition and produce a fluorescence output of a specified wavelength, which thereby maximizes the lasing efficiency of the Nd:YAG material, to provide a value close to the theoretically possible value of 91 percent at room temperature. By optimizing the lasing efficiency of the laser material in accordance with the present invention, the laser threshold, power supply requirements, and laser dimensions may be advantageously reduced. In addition the heat load on the laser crystal is reduced, which, in turn, removes thermal distortions and increases beam brightness, to permit ranging at increased distances for a given power input, as compared to some prior art lasers.

Fig. 6 shows, in schematic form, one apparatus suitable for generating the reactive atmosphere required in several process embodiments of the present invention. (The apparatus of Fig. 6 is known from U.S. Patent No. 4,315,832 and FR—A—2 450 885, respectively). High purity oxygen (99.99% pure) is provided in a container 10 which is connected to a valve 12, which is connected at its other end to the quartz or pyrex tubing 14. The tubing 14 is connected to a water trap device 16 that is immersed in a mixture of dry ice and acetone 18 in the container 20. The quartz or pyrex tubing 22 which emerges as shown from the exit of the water trap device 16 leads to a quartz or pyrex container 24 which holds iodine ($I_2$) initially in solid form. Upon activation of the heating element 26 which is located near the bottom of the container 24, the solid iodine forms the liquid 28 and is then vaporized. Optionally, the temperature in the container 24 may be controlled to produce sufficient vapor pressure directly from the solid iodine. The $I_2$ vapor mixed with the dried $O_2$ gas in the container 24 passes through the Teflon tube 30 to a connecting high purity (99.9%) alumina tube 32 which passes through a Teflon or vitreous silica cap 33 and then into a high purity alumina reaction tube 34.

With the reaction tube 34, there are one or more platinum-lined alumina boats 36 which contain the selected material 38 to be processed. The reaction tube 34 also has a high purity alumina tube 40 through which exhaust gases are removed from the reaction tube 34. The reaction tube 34 is contained within a furnace 42 which has heating elements 44 that can be controlled to raise the temperature in the furnace 42 to a predetermined level at which atomic oxygen and atomic iodine are formed from the $O_2$ and $I_2$. The method of use of the apparatus shown in Fig. 6 is described in greater detail below.

The apparatus shown in Fig. 6 may be altered as required to accommodate the use of other atomic oxygen-producing substances, such as a mixture of iodine and nitrous oxide ($N_2O$); ozone ($O_3$); or molecular oxygen ($O_2$) under electric discharge. In addition, the apparatus of Fig. 6 may be combined with an apparatus suitable for crystal growth from a melt, with the reaction tube 34 and associated heating elements shown in Fig. 6 being replaced by a crystal growth chamber and associated heating means.

More particularly, in accordance with a first process embodiment of the present invention, the minimization of undesired anion off-stoichiometry and the associated undesired defect-related dopant sites in the Nd:YAG crystal is achieved by first preparing a powder of mixed oxides, comprising, for example, $Y_2O_3$, $Nd_2O_3$, and $Al_2O_3$ in the molar ratio of 2.97:0.03:5.00. The powder is placed in a crystal growth apparatus which is suitable for crystal growth from a melt and in which a reactive atmosphere can be maintained. Such a crystal growth process may be, for example, the known Czochralski method or vertical pull method, in which a seed crystal is immersed in a melt and is then rotated while being slowly withdrawn from the melt. The heating of the melt and the rate of pulling the crystal from the melt are controlled to provide a crystal of the desired size and shape. The Czochralski method is described in more detail by J. C. Brice in the book entitled "The Growth of Crystals from Liquids", North-Holland Publishing Company, 1973. Alternatively, crystal growth may be performed by the Bridgman method, as described, for example, by Brice as referenced above.

It is also advisable to pre-clean the growth apparatus prior to introduction of the oxide powder, by treatment of the apparatus with the $I_2$ and $O_2$ reactive atmosphere discussed below, to remove water impurities from the apparatus.

The apparatus shown in Fig. 6 is used to generate the reactive atmosphere of atomic iodine and atomic oxygen, with the reaction chamber 34 and associated heating elements being replaced by the crystal growth chamber and its associated heating means. In the process of the present invention, reactive atmosphere processing is used to remove water and water-derived impurities from the metal oxide powder in order to remove defect-related sites and maximize normal sites for dopants in the crystal structure subsequently formed.

The oxide powder is placed in a crucible in the crystal growth apparatus, which is then sealed. The temperature in the crystal growth chamber is raised at 1500°C. High purity $O_2$ is introduced from the container 10 through the valve 12 at a flow rate of 6 to 7 cubic centimeters per minute into the cold trap 16, where residual water is removed from the $O_2$ by freezing in the dry ice/acetone mixture 18. The dried $O_2$ is then passed into the container 24 containing iodine vapor. The iodine vapor is produced by activating the heating element 26, which is a nichrome wire, by applying a controlled voltage to this wire, to raise the temperature in the container 24 to approximately 100°C to vaporize the $I_2$. The mixture of dry $O_2$ and $I_2$ have mole concentrations in the ratio of 10:1. The $O_2$ and $I_2$ mixture then passes through tubes 30 and 32 into the crystal growth chamber. The powder is kept at approximately 1500°C for on the order of 100 hours. At the elevated temperature in the crystal growth chamber, the reactive atmosphere of $O_2$ and $I_2$ reacts to produce atomic iodine and atomic oxygen, which react with an remove the water and water-derived impurities from the mixed oxide powder. At higher reaction temperatures, the reaction time may be reduced, but both quantities depend upon the particle size of the oxide powder.

After the mixed oxide powder has been purified, the reactive atmosphere is maintained and the powder is melted by exposure to a laser beam from a $CO_2$ laser, for example, or by application of heat. Then, the Nd:YAG crystal is grown by the known Czochralski process, for example, under the reactive atmosphere.

Alternatively, the oxide may first be purified by treatment in the apparatus shown in Fig. 6, using a reactive atmosphere of iodine and oxygen as previously described. After the oxide powder has been purified, it is then transferred to a suitable crystal growth apparatus, the powder is melted, and the crystal is grown from the melt, as discussed above. However, care must be taken at all times during the transfer of the powder to the crystal growth chamber, as well as during the crystal growth process, to assure that the purified powder and the crystal melt subsequently formed thereon are protected from any source of water contamination. This protection can best be accomplished by maintaining the powder or melt under the reactive atmosphere of $I_2$ and $O_2$ as described above. Alternatively, the purified powder may be protected from water contamination by an inert atmosphere, such as helium, rather than by the reactive atmosphere.

By the above-described process, the anion or anion-related impurities which cause unwanted defect-related dopant sites in the YAG crystal have been eliminated. Consequently, upon growth of the neodymium-doped YAG material, the neodymium dopant ions are located in the preferential single crystal site which is substantially free of crystal defects. As previously discussed herein, this preferential single crystal site (i.e., the normal site) for the neodymium dopant produces maximized lasing efficiency in the Nd:YAG crystal.

In accordance with a second process embodiment of the present invention, the process described immediately above is followed, except that the starting material is the best commercially available Nd:YAG powder.

In accordance with a third process embodiment of the present invention, a Nd:YAG crystal rod is treated with ozone at 1500°C or higher. An apparatus somewhat similar to that shown in Fig. 6 is used with the $I_2$ and $O_2$ portions being replaced by an ozone-generating system. The crystal rod sample is substituted for the powder 38 shown in Fig. 6.

In accordance with a fourth process embodiment of the present invention, a Nd:YAG crystal rod is treated with an $I_2$ and $O_2$ reactive atmosphere, using the apparatus shown in Fig. 6 and substituting the crystal rod sample for the powder 38 shown in Fig. 6. The atomic oxygen and atomic iodine formed react with and remove water and water-derived impurities from the YAG crystal. In addition, this process is performed under high pressure, such as 980 bar (100 atmospheres) or more, which promotes a condition in the crystal structure whereby the location of dopant ions in the normal site is preferred. (At this increased pressure, there is a greater difference in the energies required to populate the normal and defect-related sites than at normal pressure, with the population of the normal site being favored.) Thus, by this process embodiment of the present invention, impurities which cause unwanted defect-related sites are removed and the number of defect-related sites is decreased, while simultaneously the location of dopant ions in the normal site is promoted by the use of a high pressure. If microcracks occur in the material produced, this material can be subsequently annealed to remove the microracks.

In particular, the scope of the invention is not limited to Nd-doped YAG crystals, but is intended to include other lasing ions, such as rare earth ions and transition metal ions, and other oxide crystals and glass host materials, such as yttrium aluminum oxide ($YAlO_3$), gadolinium gallium garnet ($Gd_3Ga_5O_{12}$), yttrium vanadate ($YVO_4$), yttrium oxide ($Y_2O_3$), calcium tungstate ($CaWO_4$), calcium molybdate ($CaMoO_4$), spinel ($MgO \cdot Al_2O_3$), chrysoberyl ($BeO \cdot Al_2O_3$), sapphire ($Al_2O_3$), and glass. Nor is the present invention limited to laser materials, but includes any material in which radiation emission is extracted as a result of a given energy input, including, for example, phosphorescent material. Moreover, the basic concept of the present invention, i.e., locating dopant ions at a selected site of the host crystal structure during crystal growth, to optimize a radiation emission, applies as well to host crystals other than oxides, such as halides and sulfides. However, for materials other than oxides, alternative processes or reactive atmospheres for producing the desired effect, other than those described herein for oxides, must be used which are compatible with the chemical properties of these other materials. In addition, while the process of the present invention has been described herein with respect to laser oxide materials with cation-dopants, it is anticipated that the present invention would apply as well to maximizing the lasing efficiency of stoichiometric laser crystals, in which the laser active ion is a constituent of the crystal structure, rather than a dopant ion, such as neodymium ultra-phosphate ($NdP_5O_{12}$) or holmium fluoride.

Furthermore, it is not intended to limit the present invention to the particular processes described herein, but to include any processes by which anion stoichiometry in the crystal structure of the laser oxide material is improved or enhanced prior to and during crystal growth, which in turn, removes or prevents the formation of the anions or anion-related impurity defect sites for the dopant ions. In addition, while the present invention has been described with respect to single-crystal material, the processes of the present invention may be performed on polycrystalline, fused, or glassy materials as well.

## Claims

1. A process for maximizing the lasing efficiency of a dopant-containing laser oxide material comprising a body of said laser oxide material containing ions of said dopant, comprising the step of enhancing the anion stoichiometry in the crystal structure of said laser oxide material prior to and during the formation of said dopant-containing laser oxide material, to thereby maximize the location of said dopant ions in a single selected site of said crystal structure of said laser oxide material, said site being substantially free of defects caused by the absence of said anion stoichiometry.

2. A process for forming a crystal of a dopant-containing laser oxide material having maximized lasing efficiency, comprising the steps of:

a) providing a powdered material which serves as the source of both said laser oxide material and said dopant;

b) placing said powdered material in a crystal growth chamber adapted for growing said crystal from a melt;

c) heating said powdered material in said chamber at a predetermined elevated temperature in a reactive atmosphere comprising atomic oxygen for a predetermined period of time whereby said reactive atmosphere reacts with and removes water and water-derived impurities from said powdered material;

d) melting said powdered material in said chamber to form said melt;

e) growing said crystal of said dopant-containing laser oxide material from said melt under said reactive atmosphere, whereby, upon growth of said crystal, ions of said dopant are located at a preferential single selected site of the crystal structure of said oxide material, said site being substantially free of crystal defects caused by anion or anion-related impurities in said crystal structure, and whereby said ions produce a preferential radiative energy transition upon energetic excitation of said laser oxide material, to thereby maximize said lasing efficiency.

3. The process as set forth in Claim 2 wherein said powdered material comprises yttrium oxide ($Y_2O_3$), neodymium oxide ($Nd_2O_3$), and aluminum oxide ($Al_2O_3$) in a predetermined ratio and said dopant-containing laser oxide material is neodymium-doped yttrium aluminum garnet.

4. The process as set forth in Claim 2 wherein said powdered material comprises neodymium-doped yttrium aluminum garnet.

5. The process as set forth in Claim 4 wherein said reactive atmosphere comprising atomic oxygen is formed from a vapor mixture of iodine and oxygen at 1500°C and said predetermined time is on the order of 100 hours.

6. A process for maximizing the lasing efficiency of a body of a dopant-containing laser oxide material comprising heating said body for a predetermined period of time under a pressure of approximately 100 atmospheres in a vapor mixture of iodine and oxygen in a predetermined ratio at a predetermined temperature to thereby form atomic iodine and atomic oxygen to react with and remove water and water-derived impurities from said laser oxide material and to thereby simultaneously promote location of ions of said dopant in a single preferred site of the crystal structure of said oxide material, said preferred site being substantially free of defects caused by said impurities, whereby the population of said ions of said dopant in said preferred site is enhanced and said lasing efficiency is maximized.

7. A laser oxide material having maximized lasing efficiency comprising a selected host oxide and selected dopant ions wherein said selected dopant ions are held at a single selected site of the crystal structure of said host oxide, said site being substantially free of lattice defects induced by anion off-stoichiometry in said crystal structure, whereby a single chosen radiative energy transition is produced upon energetic excitation of said laser oxide material and said lasing efficiency of said laser oxide material is maximized.

8. The laser oxide material as set forth in Claim 7 wherein said selected host oxide is selected from the group consisting of yttrium aluminum garnet ($Y_3Al_5O_{12}$), yttrium aluminum oxide ($YAlO_3$), gadolinium gallium garnet ($Gd_3Ga_5O_{12}$),

yttrium vanadate ($YVO_4$), yttrium oxide ($Y_2O_3$), calcium tungstate ($CaWO_4$), calcium molybdate ($CaMoO_4$), spinel ($Mg \cdot Al_2O_3$), chrysoberyl ($BeO \cdot Al_2O_3$), sapphire ($Al_2O_3$), and glass.

9. The laser oxide material as set forth in Claim 7 wherein said selected dopant ions are laser-active ions selected from the group consisting of rare earth ions and transition metal ions.

10. A neodymium-doped yttrium aluminum garnet material wherein substantially all ions of said neodymium are coordinated at the normal dodecahedral site in the crystal structure of said yttrium aluminum garnet, said crystal structure possessing optimized anion stoichiometry, to provide a chosen radiative energy transition upon energetic excitation of said material and to thereby maximize the lasing energy output from said material.

11. Process for maximizing the lasing efficiency of a laser oxide crystal comprising saturating a single selected lattice site of said crystal with ions of a preselected dopant, by maximizing the anion stoichiometry within said crystal prior to and during the formation of said laser oxide crystal containing said dopant, and thereby minimizing unwanted defect-related sites in said crystal.

**Patentansprüche**

1. Verfahren zur Optimalisierung des Wirkungsgrades eines einen Dotierstoff enthaltenden Laseroxidmaterials, das einen Körper des Laseroxidmaterials umfaßt, welcher lonen des Dotierstoffes enthält, umfassend den Schritt der Erhöhung der Anionen-Stöchiometrie in der Kristallstruktur des Laseroxidmaterials vor und während der Bildung des Dotierstoff enthaltenden Laseroxidmaterials, um dadurch den Lagerort der dotierenden lonen auf einem einzelnen ausgewählten Gitterplatz der Kristallstruktur des Laseroxidmaterials zu optimalisieren, wobei der Gitterplatz im wesentlichen von Fehlern, die durch die Anwesenheit der lonen-Stöchiometrie verursacht sind, frei ist.

2. Verfahren zur Bildung eines Kristalls eines einen Dotierstoff enthaltenden Laseroxidmaterials mit optimalisiertem Laserwirkungsgrad, umfassend die Schritte:

a) Zur Verfügung Stellen eines gepulverten Materials, das als Quelle sowohl für das Laseroxidmaterial als auch für den Dotierstoff dient;

b) Anordnen des gepulverten Materials in einer Kristallwachstumskammer, die zum Ziehen des Kristalls aus einer Schmelze geeignet ist;

c) Erhitzen des gepulverten Materials in der Kammer auf eine vorbestimmte erhöhte Temperatur in einer atomaren Sauerstoff umfassenden reaktiven Atmosphäre für eine bestimmte Zeitdauer, wobei die reaktive Atmosphäre mit Wasser und von Wasser stammenden Verunreinigungen aus dem gepulverten Material reagiert und diese entfernt;

d) Schmelzen des gepulverten Materials in der Kammer zur Bildung der Schmelze;

e) Ziehen des Kristalls aus dem Dotierstoff enthaltenden Laseroxidmaterial aus der Schmelze in der reaktiven Atmosphäre, wodurch nach Wachstum des Kristalls lonen des Dotierstoffs an einen bevorzugten einzigen ausgewählten Gitterplatz der Kristallstruktur des Oxidmaterials festgelegt werden, wobei der Gitterplatz im wesentlichen frei von Kristallfehlern ist, die durch anionische oder anionenverwandte Verunreinigungen in der Kristallstruktur verursacht sind, und wobei die lonen einen bevorzugten Strahlungsenergieübergang nach energetischer Anregung des Laseroxidmaterials erzeugen, um dadurch den Laserwirkungsgrad zu optimalisieren.

3. Verfahren nach Anspruch 2, wobei das gepulverte Material Yttriumoxid ($Y_2O_3$), Neodymoxid ($Nd_2O_3$) und Aluminiumoxid ($Al_2O_3$) in einem vorbestimmten Verhältnis umfaßt und das Dotierstoff haltige Laseroxidmaterial mit Neodymdotierter Yttrium-Aluminium-Granat ist.

4. Verfahren nach Anspruch 2, wobei das gepulverte Material Methneodym-dotierten Yttrium-Aluminium-Granat umfaßt.

5. Verfahren nach Anspruch 4, wobei die atomaren Sauerstoff enthaltende reaktive Atmosphäre aus einer Dampfmischung von Jod und Sauerstoff bei 1500°C gebildet wird und die vorbestimmte Zeit in der Größenordnung von 100 Stunden liegt.

6. Verfahren zur Optimalisierung des Wirkungsgrades eines Körpers aus einem einen Dotierstoff enthaltenden Laseroxidmaterial, umfassend das Erhitzen des Körpers für eine vorbestimmte Zeitdauer unter einem Druck von etwa 100 Atmosphären in einer Dampfmischung aus Jod und Sauerstoff in einem vorbestimmten Verhältnis bei einer vorbestimmten Temperatur, um dadurch atomares Jod und atomaren Sauerstoff zu bilden, um mit Wasser und von Wasser stammenden Verunreinigungen aus dem Laseroxidmaterial zu reagieren und diese zu entfernen und dadurch gleichzeitig die Festlegung von lonen des Dotierstoffs in einem einzelnen bevorzugten Gitterplatz der Kristallstruktur des Oxidmaterials zu fördern, wobei der bevorzugte Gitterplatz im wesentlichen frei von Fehlern, welche durch die Verunreinigungen hervorgerufen sind, ist, wodurch die Besetzung der lonen des Dotierstoffs in dem bevorzugten Gitterplatz verstärkt wird und der Laserwirkungsgrad optimalisiert wird.

7. Laseroxidmaterial mit optimalisiertem Laserwirkungsgrad umfassend ein ausgewähltes Wirtsoxid und ausgewählte Dotierstoffionen, wobei die ausgewählten Dotierstoffionen auf einem einzelnen ausgewählten Gitterplatz der Kristallstruktur des Wirtsoxids gehalten wird, und wobei der Gitterplatz im wesentlichen frei von Gitterstörungen ist, die durch Anionenfehl-Stöchiometrie in der Kristallstruktur hervorgerufen sind, wodurch ein einzelner ausgewählter Strahlungsenergieübergang nach energetischer Anregung des Laseroxidmaterials erzeugt wird und der Laserwirkungsgrad des Laseroxidmaterials optimalisiert wird.

8. Laseroxidmaterial nach Anspruch 7, wobei das ausgewählte Wirtsoxid aus der folgenden Gruppe ausgewählt ist: Yttrium-Aluminium-Granat ($Y_3Al_5O_{12}$), Yttrium-Aluminium-Oxid ($YAlO_3$), Gadolinium-Gallium-Granat ($Gd_3Ga_5O_{12}$), Yttriumvanadat ($YVO_4$), Yttriumoxid ($Y_2O_3$) Calciumwolframat ($CaWO_4$), Calciummolybdat ($CaMoO_4$), Spinell ($MgAl_2O_3$), Chrysoberyll ($BeOAl_2O_3$), Saphir ($Al_2O_3$) und Glas.

9. Laseroxidmaterial nach Anspruch 7, wobei die auswählten Dotierstoffionen laseraktive Ionen aus der Gruppe: seltene Erdeionen und Übergangsmetallionen sind.

10. Mit Neodyn dotiertes Yttrium-Aluminium-Granat-Material, worin im wesentlichen alle Ionen des Neodyms auf dem normalen dodekaedrischen Gitterplatz in der Kristallstruktur des Yttrium-Aluminium-Granats koordiniert sind, und wobei die Kristallstruktur optimalisierte Anionen-Stöchiometrie besitzt, um einen ausgewählten Strahlungsenergieübergang nach energetischer Anregung des Materials zu erzeugen und dadurch die Laserenergieleistung des Materials zu optimalisieren.

11. Verfahren zur Optimalisierung des Wirkungsgrads eines Laseroxidkristalls, umfassend die Sättigung eines einzelnen ausgewählten Gitterplatzes des Kristalls mit Ionen eines ausgewählten Dotierstoffes durch Optimalisierung des Anionenstöchiometrie in dem Kristall vor und während der Bildung des Laseroxidkristalls, der den Dotierstoff enthält, und dadurch Zurückführung von unerwünschten mit Fehlern verbundenen Gitterplätzen in dem Kristall auf ein Minimum.

**Revendications**

1. Un procédé pour maximiser le rendement laser d'une matière consistant en un oxyde produisant un effet laser et contenant un dopant, se présentant sous la forme d'un bloc d'oxyde à effet laser contenant des ions du dopant précité, comprenant l'opération qui consiste à améliorer l'équilibre stoechiométrique anionique dans la structure cristalline de l'oxyde à effet laser, avant et pendant la formation de l'oxyde à effet laser contenant un dopant, pour maximiser ainsi la localisation des ions de dopant dans un seul site sélectionné de la structure cristalline de l'oxyde à effet laser, ce site étant pratiquement exempt de défauts produits par l'absence de l'équilibre stoechiométrique anionique.

2. Un procédé pour former un cristal d'un oxyde à effet laser contenant un dopant, ayant un rendement laser maximisé, comprenant les opérations suivantes:

a) on produit une matière en poudre qui fait fonction de source à la fois pour l'oxyde à effet laser et pour le dopant;

b) on place la matière en poudre dans une chambre de croissance cristalline prévue pour faire croître le cristal à partir d'un bain en fusion;

c) on chauffe la matière en poudre dans la chambre jusqu'à une température élevée prédéterminée, dans une atmosphère réactive comprenant de l'oxygène atomique, pendant une durée prédéterminée, grâce à quoi l'atmosphère réactive réagit avec de l'eau et des impuretés dérivées de l'eau et elle extrait ces dernières de la matière en poudre;

d) on fait fondre la matière en poudre dans la chambre pour former le bain en fusion;

e) on fait croître le cristal de l'oxyde à effet laser contenant un dopant, à partir du bain en fusion, dans l'atmosphère réactive, grâce à quoi, au moment de la croissance du cristal, des ions du dopant sont localisés dans un seul site sélectionné préférentiel de la structure cristalline de l'oxyde, ce site étant pratiquement exempt de défauts cristallins produits par un anion ou par des inpuretés liées à un anion dans la structure cristalline, et grâce à quoi ces ions produisent une transition énergétique radiative préférentielle sous l'effet d'une excitation énergétique de l'oxyde à effet laser, pour maximiser ainsi le rendement laser.

3. Le procédé selon la revendication 2, dans lequel la matière en poudre consiste en oxyde d'yttrium ($Y_2O_3$), en oxyde de néodyme ($Nd_2O_3$) et en oxyde d'aluminium ($Al_2O_3$) dans un rapport prédéterminé, et l'oxyde à effet laser contenant un dopant est un grenat d'yttrium-aluminium dopé au néodyme.

4. Le procédé selon la revendication 2, dans lequel la matière en poudre consiste en un grenat d'yttrium-aluminium dopé au néodyme.

5. Le procédé selon la revendication 4, dans lequel l'atmosphère réactive comprenant de l'oxygène atomique est formée à partir d'un mélange en phase vapeur d'iode et d'oxygène à 1500°C, et la durée prédéterminée est de l'ordre de 100 heures.

6. Un procédé pour maximiser le rendement laser d'un bloc d'oxyde à effet laser contenant un dopant, dans lequel on chauffe ce bloc pendant une durée prédéterminée sous une pression d'environ $10^7$ Pa, dans un mélange en phase vapeur d'iode et d'oxygène dans un rapport prédéterminé, à une température prédéterminée, pour former ainsi de l'iode atomique et de l'oxygène atomique destinés à réagir avec de l'eau et des impuretés dérivées de l'eau et à extraire celles-ci de l'oxyde à effet laser, et destinés à favoriser ainsi simultanément la localisation d'ions du dopant dans un seul site préféré de la structure cristalline de l'oxyde, ce site préféré étant pratiquement exempt de défauts produits par les impuretés, grâce à quoi la population de ces ions du dopant dans le site préféré est augmentée et le rendement laser est maximisé.

7. Un oxyde à effet laser ayant un rendement laser maximisé, comprenant un oxyde hôte sélectionné et des ions de dopant sélectionnés, dans lequel les ions de dopant sélectionnés sont maintenus à un seul site sélectionné de la structure cristalline de l'oxyde hôte, ce site étant pratiquement exempt de défauts de réseau cristallin induits par un défaut d'équilibre stoechiométrique anionique dans la structure cristalline, grâce à quoi une seule transition énergétique radiative choisie est produite sous l'effet d'une excitation énergétique de l'oxyde à effet laser, et le rendement laser de l'oxyde à effet laser est maximisé.

8. L'oxyde à effet laser selon la revendication 7, dans lequel l'oxyde hôte sélectionné est choisi dans le groupe comprenant les corps suivants: grenat d'yttrium-aluminium ($Y_3Al_5O_{12}$), oxyde d'yttrium-aluminium ($YAlO_3$), grenat de gadolinium-gallium ($Gd_3Ga_5O_{12}$), vanadate d'yttrium ($YVO_4$), oxyde d'yttrium ($Y_2O_3$), tungstate de calcium ($CaWO_4$), molybdate de calcium ($CaMoO_4$), spinelle ($Mg.Al_2O_3$), chrysobéryl ($BeO.Al_2O_3$), saphir ($Al_2O_3$) et verre.

9. L'oxyde à effet laser selon la revendication 7, dans lequel les ions de dopant sélectionnés sont des ions actifs pour l'effet laser qui sont sélectionnés dans le groupe comprenant des ions de terres rares et des ions de métaux de transition.

10. Un grenat d'yttrium-aluminium dopé au néodyme, dans lequel la quasi-totalité des ions du néodyme sont coordinés au site dodécaédrique normal dans la structure cristalline du grenat d'yttrium-aluminium, cette structure cristalline possédant des caractéristique stoechiométriques anioniques optimisées, pour produire une transition énergétique radiative choisie sous l'effet de l'excitation énergétique du grenat et pour maximiser ainsi l'énergie laser émise par le grenat.

11. Procédé pour maximiser le rendement laser d'un cristal consistant en un oxyde à effet laser, dans lequel on sature un seul site sélectionné du réseau de ce cristal avec des ions d'un dopant présélectionné, en maximisant l'équilibre stoechiométrique anionique à l'intérieur du cristal avant et pendant la formation du cristal d'oxyde à effet laser contenant le dopant, et en minimisant ainsi des sites parasites, liés à des défauts, dans le cristal.

0 067 521

Fig. 1.

Fig. 2.

1

Fig. 3.

T = 6.8K
PUMP WAVELENGTH
0.58778 μm

CURVE A

PUMP WAVELENGTH
0.58799 μm

CURVE B

Z

FLUORESCENCE AMPLITUDE PER POWER ABSORBED

0.875  0.876

WAVELENGTH, μm

Fig. 5.

T = 8K

X

FLUORESCENCE AMPLITUDE PER POWER ABSORBED

0.875  0.876

WAVELENGTH, μm

Fig. 4.

Fig. 6.